# EUROPEAN PATENT APPLICATION

(11) **EP 4 832 053 A1**
(43) Date of publication of application: **28.10.2026**
(21) Application number: 24907172.1
(22) Date of filing: 05.12.2024
(51) Int. Cl.: H01L 21/52, H01L 21/60, H01L 21/677, H01L 21/683

(54) **JOINING SYSTEM AND JOINING METHOD**

(30) Priority: 19.12.2023 JP 2023213488
(71) Applicant: Tokyo Electron Limited, Tokyo 107-6325 (JP)
(72) Inventor: KANEKO, Tomohiro, Kikuchi-gun, Kumamoto 869-1232 (JP)
(74) Representative: Hoffmann Eitle
(86) International application number: PCT/JP2024/043043
(87) International publication number: WO 2025/134786

(57) **Abstract**

A bonding system includes a plurality of bonders configured to separate dies from carriers to bond the separated dies to target substrates; a transfer apparatus configured to transfer the carriers and the target substrates to the plurality of bonders; and control circuitry configured to control the plurality of bonders and the transfer apparatus. The control circuitry is further configured to perform control to cause, during a desired period, the plurality of the bonders to repeatedly bond, to the target substrates, the only one type of the dies set for each of the plurality of the bonders while replacing the target substrates; and control to cause, during the desired period, the transfer apparatus to sequentially transfer each of the target substrates to the plurality of the bonders that are configured to bond different types of the dies to the target substrates.

## Description

### TECHNICAL FIELD

The present disclosure relates to a bonding system and a bonding method.

### BACKGROUND ART

Patent Document 1 describes a technique of bonding individual chips to a target substrate. Each chip is referred to as a die.

### RELATED ART DOCUMENTS

### PATENT DOCUMENTS

Patent Document 1: Japanese Patent Application Publication No. 2023-132650

### SUMMARY OF THE INVENTION

### PROBLEMS TO BE SOLVED BY THE INVENTION

An aspect of the present disclosure provides a technique of reducing a period for adjusting bonders.

### MEANS FOR SOLVING THE PROBLEMS

A bonding system according to an aspect of the present disclosure includes: a plurality of bonders configured to separate dies from carriers to bond the separated dies to target substrates; a transfer apparatus configured to transfer the carriers and the target substrates to the plurality of bonders; and control circuitry configured to control the plurality of bonders and the transfer apparatus. A plurality of types of the dies are provided, and the plurality of the types of the dies are distinguished by at least one of a size or an electronic circuit. A plurality of the carriers are provided, and the plurality of the carriers are configured to hold a plurality of only one type of the dies set for each of the carriers. A number of the bonders is equal to or greater than a number of the types of the dies. The control circuitry is further configured to perform: control to cause, during a desired period, the plurality of the bonders to repeatedly bond, to the target substrates, the only one type of the dies set for each of the plurality of the bonders while replacing the target substrates; and control to cause, during the desired period, the transfer apparatus to sequentially transfer each of the target substrates to the plurality of the bonders that are configured to bond different types of the dies to the target substrates.

### ADVANTAGEOUS EFFECTS OF THE INVENTION

According to an aspect of the present disclosure, it is possible to reduce a period for adjusting bonders.

### BRIEF DESCRIPTION OF THE DRAWINGS

[FIG. 1] FIG. 1 is a plan diagram illustrating a bonding system according to an embodiment.
[FIG. 2] FIG. 2(A) is a cross-sectional diagram illustrating an example of a target substrate, and FIG. 2(B) is a cross-sectional diagram illustrating an example of dies bonded to the target substrate.
[FIG. 3] FIG. 3(A) is a cross-sectional diagram illustrating an example of a plurality of first dies attached to a first carrier, FIG. 3(B) is a cross-sectional diagram illustrating an example of a plurality of second dies attached to a second carrier, FIG. 3(C) is a cross-sectional diagram illustrating an example of a plurality of third dies attached to a third carrier, and FIG. 3(D) is a cross-sectional diagram illustrating an example of a plurality of fourth dies attached to a fourth carrier.
[FIG. 4] FIG. 4 is a flowchart illustrating a bonding method according to an embodiment.
[FIG. 5] FIG. 5 is a plan diagram illustrating a bonder according to an embodiment.
[FIG. 6] FIG. 6 is a cross-sectional diagram illustrating an example of an operation of the bonder.
[FIG. 7] FIG. 7 is a cross-sectional diagram illustrating an example of the operation of the bonder following FIG. 6.
[FIG. 8] FIG. 8(A) is a cross-sectional diagram illustrating an example of a structure of a tip of an adsorption head, and FIG. 8(B) is a plan diagram illustrating an example of the structure of the tip of the adsorption head.
[FIG. 9] FIG. 9(A) is a cross-sectional diagram illustrating an example of a relative position of a first die with respect to the adsorption head, and FIG. 9(B) is a plan diagram illustrating an example of the relative position of the first die with respect to the adsorption head.
[FIG. 10] FIG. 10 is a plan diagram illustrating a first example of carry-in/out of a first carrier with respect to the bonder.
[FIG. 11] FIG. 11 is a plan diagram illustrating a second example of the carry-in/out of the first carrier with respect to the bonder.
[FIG. 12] FIG. 12 is a plan diagram illustrating a first example of carry-in/out of a target substrate with respect to the bonder.
[FIG. 13] FIG. 13 is a plan diagram illustrating a second example of the carry-in/out of the target substrate with respect to the bonder.
[FIG. 14] FIG. 14 is a plan diagram illustrating a third example of the carry-in/out of the target substrate with respect to the bonder.
[FIG. 15] FIG. 15 is a diagram illustrating an example of a period that can be reduced by a plurality of bonders each configured to bond only one type of dies, set for each bonder, to the target substrates.
[FIG. 16] FIG. 16 is a diagram illustrating an example of types of dies to be bonded to the target substrate by each bonder when the number of the bonders is greater than the number of the types of the dies.
[FIG. 17] FIG. 17 is a diagram illustrating an example of types of dies to be bonded to the target substrate by each bonder when the number of the bonders is less than the number of the types of the dies.

### DETAILED DESCRIPTION OF THE INVENTION

Hereinafter, embodiments of the present disclosure will be described with reference to the drawings. Note in the drawings that the same or corresponding components are denoted by the same reference signs, and thus descriptions thereof may be omitted. In the present specification, an X-axis direction, a Y-axis direction, and a Z-axis direction are perpendicular to each other. The X-axis direction and the Y-axis direction are horizontal directions, and the Z-axis direction is a vertical direction. The X-axis direction includes a positive X-axis direction and a negative X-axis direction, which is opposite to the positive X-axis direction. The Y-axis direction includes a positive Y-axis direction and a negative Y-axis direction, which is opposite to the positive Y-axis direction. The Z-axis direction includes a positive Z-axis direction and a negative Z-axis direction, which is opposite to the positive Z-axis direction.

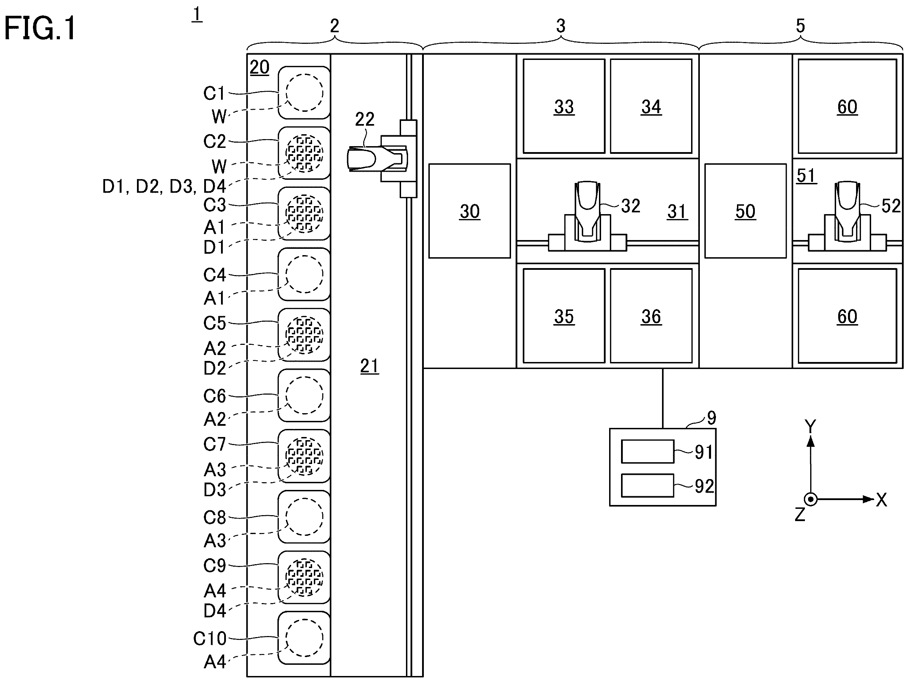

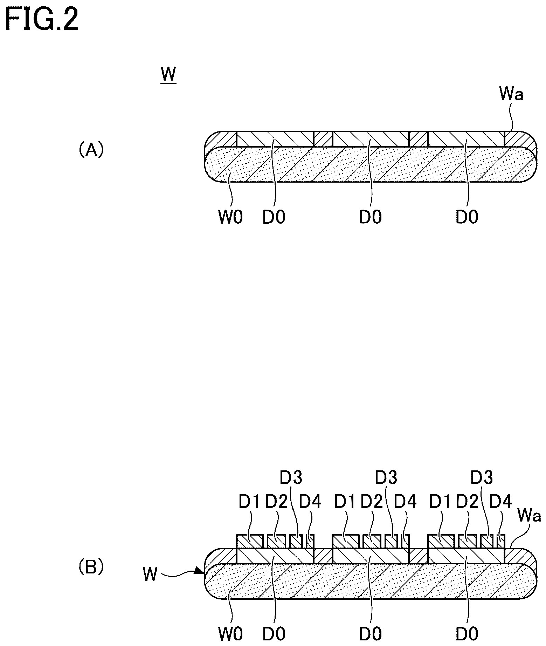

A bonding system 1 according to an embodiment will be described with reference to FIG. 1. The bonding system 1 is configured to separate a die from a carrier to bond the separated die to a target substrate W. As illustrated in FIG. 2(A), the target substrate W includes a semiconductor substrate WO, such as a silicon wafer or the like, and a plurality of devices D0 formed over the semiconductor substrate WO. The plurality of devices D0 are partitioned by a plurality of streets orthogonal to each other. Each device D0 includes an electronic circuit. As illustrated in FIG. 2(B), dies are electrically connected to each device D0. Subsequently, the target substrate W is cut along the streets into individual pieces for each device D0, thereby obtaining semiconductor devices. The semiconductor device includes the device D0 and the dies.

Each die is obtained by cutting a semiconductor substrate, on which a plurality of devices different from the device D0 are formed, into individual pieces for each device. The electronic circuit of the die is electrically connected to the electronic circuit of the device D0 of the target substrate W. The dies include, for example, first dies D1, second dies D2, third dies D3, and fourth dies D4. The first dies D1, the second dies D2, the third dies D3, and the fourth dies D4 are different from each other in at least one of a size or an electronic circuit. A type of the die is distinguished by at least one of the size or the electronic circuit.

One or more of each of the first dies D1, the second dies D2, the third dies D3, and the fourth dies D4 are electrically connected to the single device D0. No particular limitation is imposed on the type and number of the dies electrically connected to the single device D0. Although not illustrated, a plurality of the first dies D1 may be electrically connected to the single device D0. The number of the first dies D1 electrically connected to the single device D0 may be different from the number of the second dies D2 electrically connected to the single device D0.

The carrier is configured to hold a plurality of dies. The carrier holds each die with the bonding surface of each die facing upward. This enables activation and hydrophilization of the bonding surface of each die. The carrier is provided for each type of die. The carrier holds only one type of die set for each carrier, and does not hold different types of dies. The carrier includes, for example, a first carrier A1, a second carrier A2, a third carrier A3, and a fourth carrier A4.

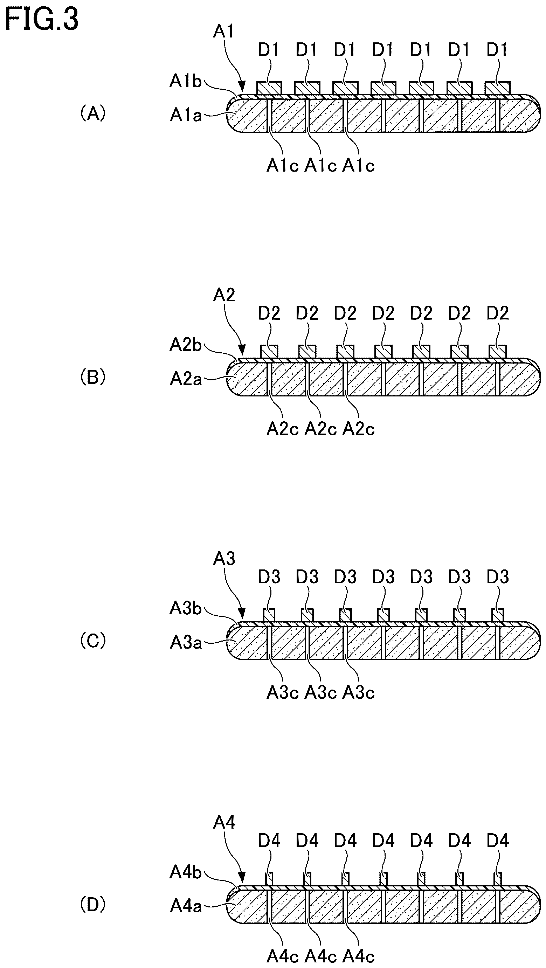

An example of the first carrier A1 will be described with reference to FIG. 3(A). The first carrier A1 is configured to hold a plurality of the first dies D1. The first carrier A1 includes a carrier substrate A1a and a resin film A1b, and is configured to electrostatically adsorb the first dies D1 on the side opposite to the carrier substrate A1a with respect to the resin film A1b. By pressing the first dies D1 against the resin film A1b, the resin film A1b can deform to remove gas from between the first dies D1 and the resin film A1b, which enables vacuum adsorption of the first dies D1 to the resin film A1b.

The carrier substrate A1a may be conductive or insulating. The carrier substrate A1a may include through-holes A1c that are formed to penetrate through the carrier substrate A1a in the thickness direction. The first dies D1 can be separated from the first carrier A1 by supplying gas into the through-holes A1c or inserting pins (not shown) into the through-holes A1c. No particular limitation is imposed on the number and arrangement of the through-holes A1c. One or more through-holes A1c may be formed for each of the first dies D1.

The resin film A1b is preferably formed of a material having flexibility, specifically, a material having an elastic modulus of 2 GPa or less and more preferably 0.5 GPa or less. The resin film A1b is preferably formed, for example, of polyimide or EVA (ethylene-vinyl acetate copolymer) from the viewpoint of durability when the bonding surfaces of the first dies D1 are modified. The thickness of the resin film A1b is, for example, 10 µm. The resin film A1b is monolayered in the present embodiment, but may be multilayered. For example, the resin film A1b may include a polyolefin layer and an acrylic adhesive layer.

Although the resin film A1b covers the through-holes A1c of the carrier substrate A1a in the present embodiment, the resin film A1b may include through-holes (not shown) communicating with the through-holes A1c. These through-holes (not shown) may penetrate through the resin film A1b in the thickness direction. In this case, the dies D can be pressed directly. The diameters of the through-holes of the resin film A1b are preferably smaller than the diameters of the through-holes A1c of the carrier substrate A1a.

Although not illustrated, the first carrier A1 may include a frame and tape covering the opening of the frame. The plurality of the first dies D1 may be arranged in the tape.

As illustrated in FIG. 3(B), the second carrier A2 is configured to hold a plurality of the second dies D2. Similar to the first carrier A1, the second carrier A2 may include a carrier substrate A2a, a resin film A2b, and through-holes A2c. Since the structure of the second carrier A2 is the same as that of the first carrier A1, a detailed description thereof will be omitted. Similar to the first carrier A1, the second carrier A2 may include a frame and tape covering the opening of the frame.

As illustrated in FIG. 3(C), the third carrier A3 is configured to hold a plurality of the third dies D3. Similar to the first carrier A1, the third carrier A3 may include a carrier substrate A3a, a resin film A3b, and through-holes A3c. Since the structure of the third carrier A3 is the same as that of the first carrier A1, a detailed description thereof will be omitted. Similar to the first carrier A1, the third carrier A3 may include a frame and tape covering the opening of the frame.

As illustrated in FIG. 3(D), the fourth carrier A4 is configured to hold a plurality of the fourth dies D4. Similar to the first carrier A1, the fourth carrier A4 may include a carrier substrate A4a, a resin film A4b, and through-holes A4c. Since the structure of the fourth carrier A4 is the same as that of the first carrier A1, a detailed description thereof will be omitted. Similar to the first carrier A1, the fourth carrier A4 may include a frame and tape covering the opening of the frame.

As illustrated in FIG. 1, the bonding system 1 includes a carry-in/out station 2, a first processing station 3, a second processing station 5, and control circuitry 9. The carry-in/out station 2, the first processing station 3, and the second processing station 5 are arranged in a row in this order from the negative X-axis direction side to the positive X-axis direction side. Although not illustrated, a plurality of the second processing stations 5 may be provided, and the plurality of the second processing stations 5 may be arranged in a row from the negative X-axis direction side to the positive X-axis direction side.

The carry-in/out station 2 includes a mounting table 20. Cassettes C1 to C10 are placed on the mounting table 20. The cassette C1 is configured to house the target substrate W before the first dies D1 or the like are bonded. The cassette C2 is configured to house the target substrate W after the first dies D1 or the like are bonded. The cassette C3 is configured to house the first carrier A1 before the first dies D1 are separated. The cassette C4 is configured to house the first carrier A1 after the first dies D1 are separated. The cassette C5 is configured to house the second carrier A2 before the second dies D2 are separated. The cassette C6 is configured to house the second carrier A2 after the second dies D2 are separated. The cassette C7 is configured to house the third carrier A3 before the third dies D3 are separated. The cassette C8 is configured to house the third carrier A3 after the third dies D3 are separated. The cassette C9 is configured to house the fourth carrier A4 before the fourth dies D4 are separated. The cassette C10 is configured to house the fourth carrier A4 after the fourth dies D4 are separated.

The carry-in/out station 2 includes a first transfer region 21 and a first transfer apparatus 22. The first transfer region 21 is next to the mounting table 20. The first transfer region 21 extends in the Y-axis direction. The first transfer apparatus 22 includes a transfer arm. The transfer arm is configured to hold and transfer the target substrate W and the carrier in the first transfer region 21. The number of the transfer arms may be one or more. The transfer arm for the target substrate W and the transfer arm for the carrier may be provided separately. The first transfer apparatus 22 includes a driver (not shown) configured to move or rotate the transfer arm. The transfer arm can move in the horizontal direction (both the X-axis direction and the Y-axis direction) and the vertical direction (the Z-axis direction) and can rotate about the vertical axis.

The first processing station 3 includes a first storage 30. The first storage 30 is next to the first transfer region 21. The first storage 30 is disposed on the opposite side of the mounting table 20 with respect to the first transfer region 21. The first storage 30 is configured to temporarily store the target substrate W and the carrier. The first storage 30 includes a plurality of stages arranged in the vertical direction. The target substrate W and the carrier are placed on each of the stages. The stage for the target substrate W and the stage for the carrier may be separately provided.

The first processing station 3 includes a second transfer region 31 and a second transfer apparatus 32. The second transfer region 31 is next to the first storage 30, and extends from the first storage 30 in the positive X-axis direction. The second transfer apparatus 32 includes a transfer arm. The transfer arm is configured to hold and transfer the target substrate W and the carrier in the second transfer region 31. The number of the transfer arms may be one or more. The transfer arm for the target substrate W and the transfer arm for the carrier may be provided separately. The second transfer apparatus 32 includes a driver (not shown) configured to move or rotate the transfer arm. The transfer arm can move in the horizontal direction (both the X-axis direction and the Y-axis direction) and the vertical direction (the Z-axis direction) and can rotate about the vertical axis.

The first processing station 3 includes a first activating apparatus 33, a first hydrophilizing apparatus 34, a second activating apparatus 35, and a second hydrophilizing apparatus 36. The first activating apparatus 33, the first hydrophilizing apparatus 34, the second activating apparatus 35, and the second hydrophilizing apparatus 36 are next to the second transfer region 31, and are provided on the positive Y-axis direction side or the negative Y-axis direction side of the second transfer region 31.

The first activating apparatus 33 is configured to activate the bonding surface of the die with the die being held by the carrier. The first activating apparatus 33 is, for example, a plasma processing apparatus. In the first activating apparatus 33, for example, an oxygen gas, which is a processing gas, is excited under reduced pressure to be formed into a plasma and ionized. By irradiating the bonding surface of the die with oxygen ions, the bonding surface of the die is activated. The processing gas is not limited to the oxygen gas, and may be a nitrogen gas or the like.

The first hydrophilizing apparatus 34 is configured to hydrophilize the bonding surface of the die with the die being held by the carrier. For example, the first hydrophilizing apparatus 34 is configured to supply pure water (e.g., deionized water) onto the die while rotating the carrier held by a spin chuck. The pure water imparts OH groups to the previously activated bonding surface of the die. The die and the target substrate W can be bonded to each other using hydrogen bonds between the OH groups.

The second activating apparatus 35 is configured to activate a bonding surface Wa of the target substrate W. The second activating apparatus 35 is, for example, a plasma processing apparatus. In the second activating apparatus 35, for example, an oxygen gas, which is a processing gas, is excited under reduced pressure to be formed into a plasma and ionized. By irradiating the bonding surface Wa of the target substrate W with oxygen ions, the bonding surface Wa of the target substrate W is activated. The processing gas is not limited to the oxygen gas, and may be a nitrogen gas or the like.

The second hydrophilizing apparatus 36 is configured to hydrophilize the bonding surface Wa of the target substrate W. For example, the second hydrophilizing apparatus 36 is configured to supply pure water (e.g., deionized water) onto the target substrate W while rotating the target substrate W held by a spin chuck. The pure water imparts OH groups to the previously activated bonding surface Wa of the target substrate W. The die and the target substrate W can be bonded to each other using hydrogen bonds between the OH groups.

The second processing station 5 includes a second storage 50. The second storage 50 is next to the second transfer region 31. The second storage 50 is disposed on the opposite side of the first storage 30 with respect to the second transfer region 31. The second storage 50 is configured to temporarily store the target substrate W and the carrier. The second storage 50 includes a plurality of stages arranged in the vertical direction. At least one of the target substrate W or the carrier is placed on each of the stages. The stage for the target substrate W and the stage for the carrier may be separately provided.

The second processing station 5 includes a third transfer region 51 and a third transfer apparatus 52. The third transfer region 51 is next to the second storage 50, and extends from the second storage 50 in the positive X-axis direction. The third transfer apparatus 52 includes a transfer arm. The transfer arm is configured to hold and transfer the target substrate W and the carrier in the third transfer region 51. The number of the transfer arms may be one or more. The transfer arm for the target substrate W and the transfer arm for the carrier may be provided separately. The third transfer apparatus 52 includes a driver (not shown) configured to move or rotate the transfer arm. The transfer arm can move in the horizontal direction (both the X-axis direction and the Y-axis direction) and the vertical direction (the Z-axis direction) and can rotate about the vertical axis.

The second processing station 5 includes bonders 60. The bonders 60 are next to the third transfer region 51, and are provided on the positive Y-axis direction side or the negative Y-axis direction side of the third transfer region 51. Each of the bonders 60 is configured to separate the dies from the carrier to bond the separated dies to the target substrate W with the bonding surfaces of the separated dies facing the bonding surface Wa of the target substrate W. Details of the bonder 60 will be described below.

The control circuitry 9 is, for example, a computer, and includes an arithmetic unit 91, such as a CPU (Central Processing Unit) or the like, and a storage unit 92, such as a memory or the like. The storage unit 92 is configured to store a program controlling various processes executed in the bonding system 1. The control circuitry 9 controls the operation of the bonding system 1 by causing the arithmetic unit 91 to execute the program stored in the storage unit 92. Lower-level control circuitry configured to control the operation of each device forming the bonding system 1 may be provided, and higher-level control circuitry configured to control a plurality of pieces of the lower-level control circuitry may be provided. The lower-level control circuitry and the higher-level control circuitry may form the control circuitry 9.

The control circuitry 9 includes an electronic circuit, such as a CPU, an FPGA (Field Programmable Gate Array), an ASIC (Application Specific Integrated Circuit), or the like, and executes various controls described in the present specification by executing instruction codes stored in a memory or by being designed as a circuit for a special application.

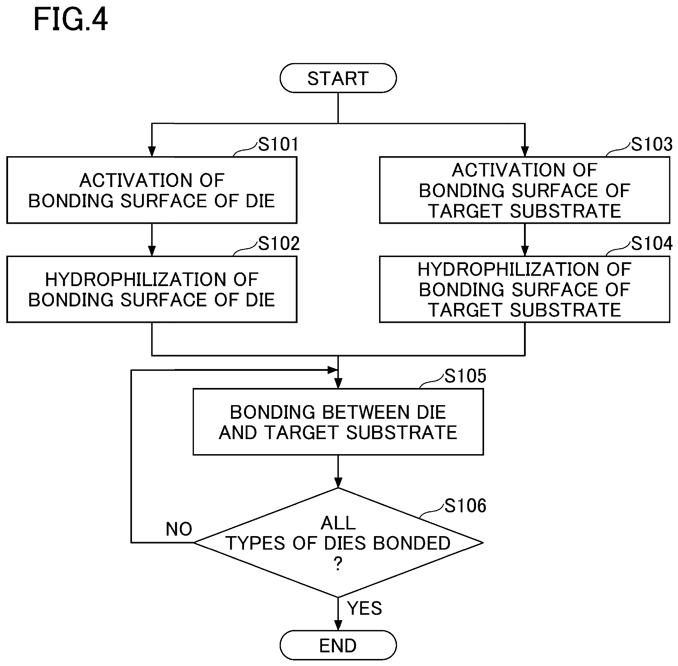

Next, a bonding method according to an embodiment will be described with reference to FIG. 4. The process illustrated in FIG. 4 is executed under the control of the control circuitry 9. First, the first transfer apparatus 22 takes out the carriers from the cassettes C3, C5, C7, and C9, and transfers the taken-out carriers to the first storage 30. Next, the second transfer apparatus 32 takes out the carrier from the first storage 30, and transfers the taken-out carrier to the first activating apparatus 33.

Next, the first activating apparatus 33 activates the bonding surfaces of the dies with the dies being held by the carrier (step S101). Subsequently, the second transfer apparatus 32 takes out the carrier from the first activating apparatus 33, and transfers the taken-out carrier to the first hydrophilizing apparatus 34.

Next, the first hydrophilizing apparatus 34 hydrophilizes the bonding surfaces of the dies with the dies being held by the carrier (step S102). Subsequently, the second transfer apparatus 32 takes out the carrier from the first hydrophilizing apparatus 34, and transfers the taken-out carrier to the second storage 50. Subsequently, the third transfer apparatus 52 takes out the carrier from the second storage 50, and transfers the taken-out carrier to the bonder 60.

In parallel to steps S101 and S102 described above, steps S103 and S104 described below are performed. First, the first transfer apparatus 22 takes out the target substrate W from the cassette C1, and transfers the taken-out target substrate W to the first storage 30. Next, the second transfer apparatus 32 takes out the target substrate W from the first storage 30, and transfers the taken-out target substrate W to the second activating apparatus 35.

Next, the second activating apparatus 35 activates the bonding surface Wa of the target substrate W (step S103). Subsequently, the second transfer apparatus 32 takes out the target substrate W from the second activating apparatus 35, and transfers the taken-out target substrate W to the second hydrophilizing apparatus 36.

Next, the second hydrophilizing apparatus 36 hydrophilizes the bonding surface Wa of the target substrate W (step S104). Subsequently, the second transfer apparatus 32 takes out the target substrate W from the second hydrophilizing apparatus 36, and transfers the taken-out target substrate W to the second storage 50. Subsequently, the third transfer apparatus 52 takes out the target substrate W from the second storage 50, and transfers the taken-out target substrate W to the bonder 60.

Next, the bonder 60 separates the dies from the carrier to bond the separated dies to the target substrate W with the bonding surfaces of the separated dies facing the bonding surface Wa of the target substrate W (step S105). The bonding between the dies and the target substrate W is performed for each type of the dies. For the single target substrate W, bonding of the first dies D1 is repeatedly performed, followed by repeatedly performing bonding of the second dies D2, followed by repeatedly performing bonding of the third dies D3. Finally, bonding of the fourth dies D4 is repeatedly performed.

When bonding of one type of die (e.g., the first dies D1) is to be followed by bonding of another type of die (e.g., the second die D2), the target substrate W is stored in the second storage 50 or the first storage 30 until the target substrate W is transferred to the bonder 60 again. The bonding of one type of die (e.g., the first dies D1) to the target substrate W and the bonding of another type of die (e.g., the second dies D2) to the target substrate W may be performed by the same bonder 60 or different bonders 60.

The target substrate W to which all types of dies have been bonded is transferred to the cassette C2. First, the third transfer apparatus 52 takes out the target substrate W, to which all types of dies have been bonded, from the bonder 60, and transfers the taken-out target substrate W to the second storage 50. Next, the second transfer apparatus 32 takes out the target substrate W, to which all types of dies have been bonded, from the second storage 50, and transfers the taken-out target substrate W to the first storage 30. Finally, the first transfer apparatus 22 takes out the target substrate W, to which all types of dies have been bonded, from the first storage 30, and stores the taken-out target substrate W in the cassette C2.

The carriers from which the dies have been separated are stored in the cassettes C4, C6, C8, and C10. First, the third transfer apparatus 52 takes out the carriers, from which the dies have been separated, from the bonder 60, and transfers the taken-out carriers to the second storage 50. Next, the second transfer apparatus 32 takes out the carriers, from which the dies have been separated, from the second storage 50, and transfers the taken-out carriers to the first storage 30. Finally, the first transfer apparatus 22 takes out the carriers, from which the dies have been separated, from the first storage 30, and stores the taken-out carriers in the cassette C4, C6, C8, or C10.

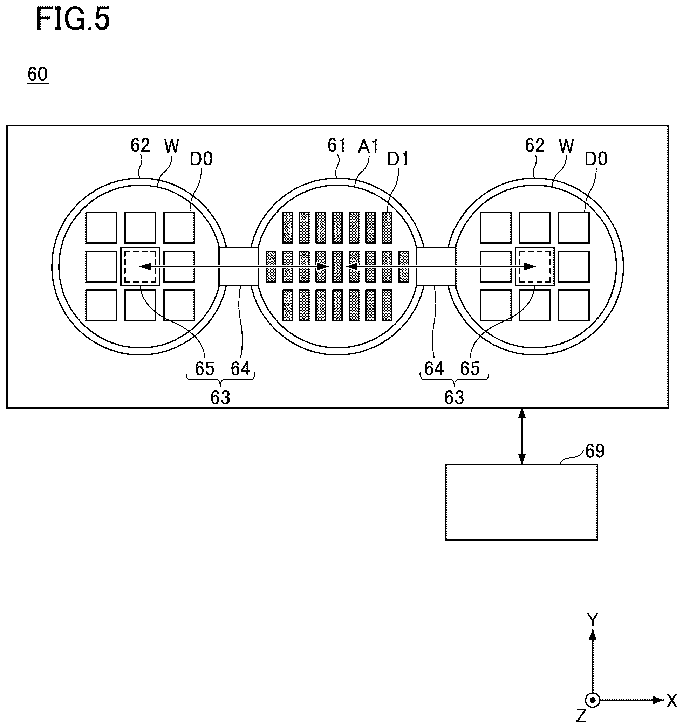

Next, an example of the bonder 60 will be described with reference to FIG. 5. The following description will be made using a case in which the bonder 60 separates the first dies D1 from the first carrier A1 to bond the separated first dies D1 to the target substrate W. Note that the bonder 60 can separate the second dies D2 from the second carrier A2 to bond the separated second dies D2 to the target substrate W; can separate the third dies D3 from the third carrier A3 to bond the separated third dies D3 to the target substrate W; and can separate the fourth dies D4 from the fourth carrier A4 to bond the separated fourth dies D4 to the target substrate W.

The bonder 60 includes, for example, a carrier holder 61, substrate holders 62, transfer sections 63, and control circuitry 69. The carrier holder 61 is configured to hold the first carrier A1. Each of the substrate holders 62 is configured to hold the target substrate W. Each of the transfer sections 63 is configured to transfer the first dies D1 from the first carrier A1, held by the carrier holder 61, to the target substrate W, held by the substrate holder 62. The control circuitry 69 may be a part of the control circuitry 9.

The bonder 60 preferably includes a plurality of the substrate holders 62 and a plurality of the transfer sections 63. Each of the plurality of the transfer sections 63 is configured to transfer the first dies D1 from one first carrier A1 held by one carrier holder 61 to the plurality of the target substrates W held by the plurality of the substrate holders 62. The transfer section 63 is provided for each of the substrate holders 62. The substrate holders 62, which are the transfer destinations, are different for each of the transfer sections 63. The carrier holder 61, which is the transfer source, is common to the plurality of the transfer sections 63. The number of the substrate holders 62 and the number of the transfer sections 63 may be the same, and may be greater than the number of the carrier holders 61.

According to the present embodiment, as described above, the carrier holder 61, which is the transfer source, is common to the plurality of transfer sections 63. Therefore, the number of the carrier holders 61 can be reduced while maintaining the number of the substrate holders 62, compared to a case in which a plurality of bonders each including one carrier holder 61, one substrate holder 62, and one transfer section 63 are arranged. This can reduce the footprint (installation area) of the bonders 60.

Preferably, the control circuitry 69 is configured to compare a code indicating the quality of the device D0 with a code indicating the quality of the first dies D1, and select a combination of the device D0 and the first dies D1 to be electrically connected. The quality of the device and the quality of the first dies D1 may be expressed by the same code. In this case, the device D0 and the first dies D1 to be electrically connected have the same code. The quality of the device D0 and the quality of the first dies D1 may be expressed by different codes. When there is a combination table of the codes, the combination can be selected.

The control circuitry 69 electrically connects the device D0 of high quality and the first dies D1 of high quality. Also, the control circuitry 69 electrically connects the device D0 of low quality and the first dies D1 of low quality. This can improve the yield of the semiconductor device. Further, the price of the semiconductor device can be set according to the quality of the semiconductor device. The semiconductor device is obtained by bonding all types of dies to the target substrate W, followed by dividing the target substrate W into individual pieces for each device D0.

It is particularly effective for the bonder 60 to include the plurality of the substrate holders 62 for one carrier holder 61 when selecting a combination by comparing the quality of the device D0 with the quality of the first dies D1. As the number of the substrate holders 62 increases, the number of the target substrates W and the number of the devices D0 increase, which increases the probability of success of the combination between the device D0 and the first dies D1. Therefore, it is possible to reduce the frequency of replacement of the first carrier A1. The number of the substrate holders 62 is two in the present embodiment, but may be three or more.

Although described below in detail, even if the first dies D1 are left on the first carrier A1, in the absence of first dies D1 combinable with the device D0 from the viewpoint of quality, the control circuitry 69 generates a command to carry this first carrier A1 out from the bonder 60 and a command to carry another first carrier A1 into the bonder 60. According to the present embodiment, the probability of success of the combination between the device D0 and the first dies D1 is high, and thus the frequency of replacement of the first carrier A1 can be reduced.

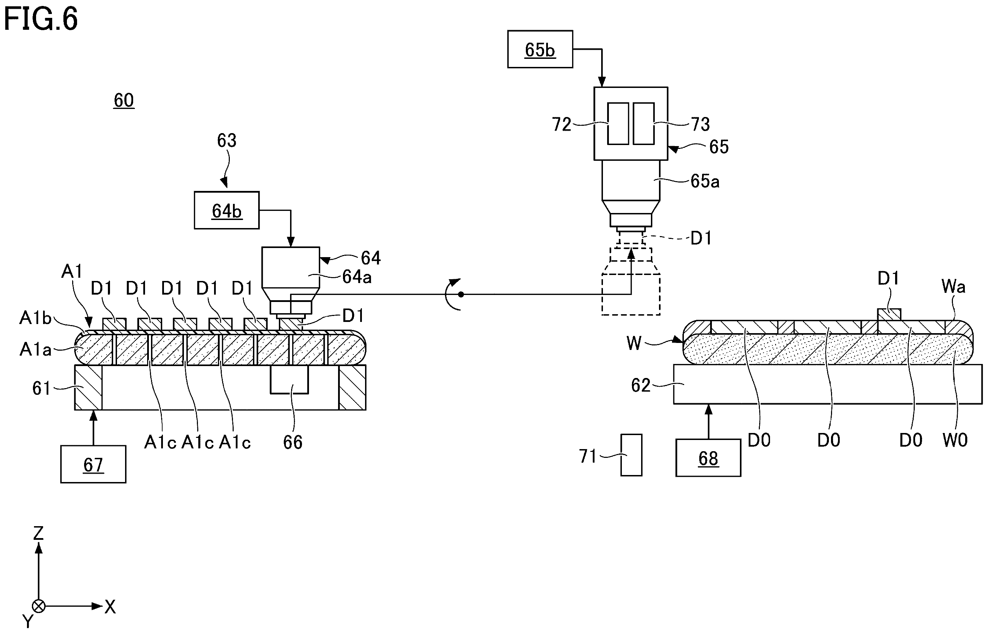

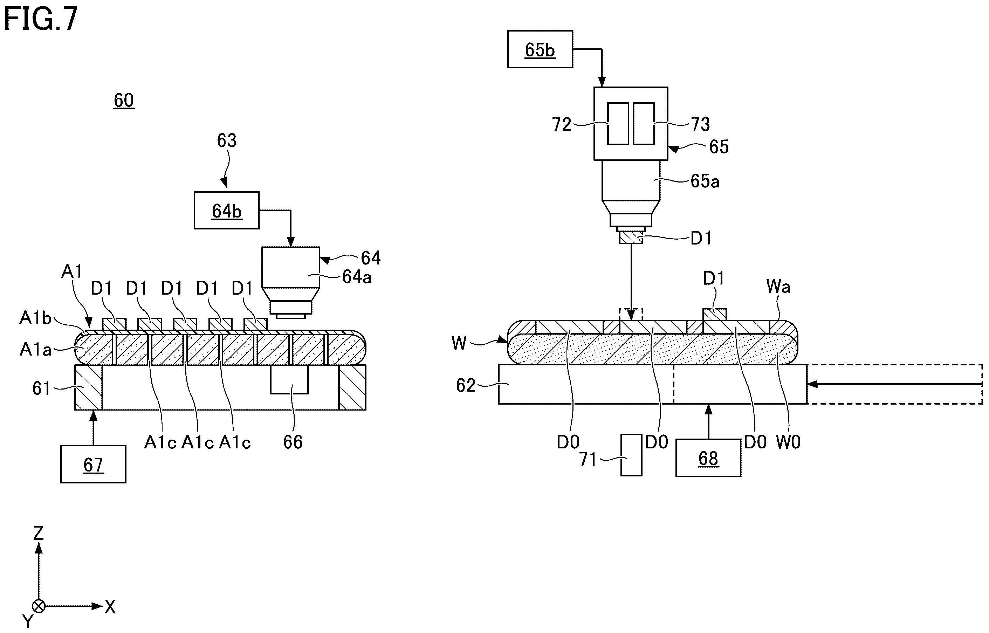

Next, an example of the transfer section 63 will be described with reference to FIGS. 6 and 7. The transfer section 63 includes a pickup portion 64 and a mounting portion 65. The pickup portion 64 is configured to separate the first dies D1 from the first carrier A1 held by the carrier holder 61, and transfer the separated first dies D1. The pickup portion 64 may vertically invert the first dies D1 during the transfer of the first dies D1. The bonding surfaces of the first dies D1 can be directed downward. The mounting portion 65 is configured to receive the first dies D1 from the pickup portion 64, and bond the received first dies D1 to the target substrate W held by the substrate holder 62.

The pickup portion 64 includes, for example, an adsorption head 64a and a moving mechanism 64b. The adsorption head 64a adsorbs the first die D1. The adsorption head 64a adsorbs the bonding surface of the first die D1. Thus, the adsorption head 64a may adsorb the bonding surface in a non-contact manner to avoid contaminating the bonding surface. The moving mechanism 64b moves the adsorption head 64a in the X-axis direction, the Y-axis direction, and the Z-axis direction. Also, the moving mechanism 64b may vertically invert the first die D1 by vertically inverting the adsorption head 64a. The bonding surface of the first die D1 can be inverted vertically.

The mounting portion 65 includes, for example, an adsorption head 65a and a moving mechanism 65b. The adsorption head 65a adsorbs the first die D1 from the side opposite to the side adsorbed by the adsorption head 64a. The adsorption head 65a adsorbs the surface opposite to the bonding surface of the first die D1. Contamination of the surface opposite to the bonding surface does not matter. Thus, the adsorption head 65a may contact the first die D1. This can increase the adsorption force to suppress displacement.

The moving mechanism 65b moves the adsorption head 65a in the Z-axis direction to bond the first die D1 to the target substrate W. In order to improve the accuracy of the bonding position, the moving mechanism 65b may move the adsorption head 65a in the X-axis direction and the Y-axis direction, or may rotate the adsorption head 65a about the vertical axis. The amount of movement or rotation required for improving the accuracy of the bonding position may be small, resulting in substantially no movement of the adsorption head 65a when viewed from above.

Next, an example of the bonder 60 will be described again with reference to FIGS. 6 and 7. The bonder 60 may include a pressing portion 66. The pressing portion 66 is configured to push the first die D1 in a direction (e.g., upward) in which the first die D1 is separated from the resin film A1b, for example, by supplying gas into the through-hole A1c of the carrier substrate A1a, or inserting a pin (not shown) into the through-hole A1c. The pressing portion 66 may be absent when the first die D1 is separable from the first carrier A1 by the pickup portion 64 just raising the first die D1 along with the adsorption head 64a.

The bonder 60 may include a carrier moving portion 67. The carrier moving portion 67 is configured to move the first carrier A1 along with the carrier holder 61. For example, the carrier moving portion 67 moves the first carrier A1 in the X-axis direction and the Y-axis direction. Thus, even if the pressing portion 66 does not move in the X-axis direction and the Y-axis direction, the pressing portion 66 can push the plurality of the first dies D1 in a desired order. The pickup portion 64 can receive the first die D1 at the same receiving position every time. This can simplify the operation of the pickup portion 64. The carrier moving portion 67 may move the first carrier A1 in the Z-axis direction.

The carrier moving portion 67 may be absent from the bonder 60. That is, the carrier holder 61 may be fixed. In this case, the receiving position changes for each of the first dies D1. Therefore, in accordance with the change in the receiving position, the pressing portion 66 is moved in the X-axis direction and the Y-axis direction.

The bonder 60 may include a substrate moving portion 68. The substrate moving portion 68 is configured to move the target substrate W along with the substrate holder 62. For example, the substrate moving portion 68 moves the target substrate W in the X-axis direction and the Y-axis direction. Thus, it is possible to change the bonding position of the first die D1 with respect to the target substrate W. As a result, the pickup portion 64 can deliver the first dies D1 to the mounting portion 65 at the same delivery position every time. This can simplify the operation of the pickup portion 64. The substrate moving portion 68 may move the target substrate W in the Z-axis direction.

In order to improve the accuracy of the bonding position of the first die D1 with respect to the target substrate W, the bonder 60 may include at least one of a first imaging portion 71, a second imaging portion 72, or a third imaging portion 73. The first imaging portion 71, the second imaging portion 72, and the third imaging portion 73 do not need to capture an image every time the first die D1 is bonded to the target substrate W, and may capture an image periodically.

As illustrated in FIG. 6, the first imaging portion 71 is configured to capture an image of alignment marks on the bonding surface (e.g., the lower surface) of the first die D1 held by the adsorption head 65a. The number of the alignment marks to be captured is, for example, two, which is by no means a limitation. The alignment marks may be dedicated marks, or may be a part of the electronic circuit of the first die D1.

The first imaging portion 71 is disposed, for example, below the adsorption head 65a. The first imaging portion 71 transmits the captured image to the control circuitry 69. The control circuitry 69 performs image processing on the image captured by the first imaging portion 71, thereby detecting the position of the first die D1 in a first coordinate system set in the adsorption head 65a.

As illustrated in FIG. 7, the second imaging portion 72 is configured to capture an image of alignment marks on the bonding surface Wa of the target substrate W held by the substrate holder 62. The number of the alignment marks to be captured is, for example, two, which is by no means a limitation. The alignment marks may be dedicated marks, or may be a part of the electronic circuit of the device D0 of the target substrate W.

The second imaging portion 72 is disposed, for example, above the substrate holder 62, and is provided, for example, in the adsorption head 65a. The second imaging portion 72 transmits the captured image to the control circuitry 69. The control circuitry 69 performs image processing on the image captured by the second imaging portion 72, thereby detecting the position of the device D0 in a second coordinate system set in the substrate holder 62.

The control circuitry 69 aligns the first die D1 held by the adsorption head 65a with the device D0 of the target substrate W held by the substrate holder 62 using the image captured by at least one of the first imaging portion 71 or the second imaging portion 72. The alignment is performed by controlling at least one of the moving mechanism 65b or the substrate moving portion 68. Before bonding between the first die D1 and the target substrate W, the position of the first die D1 or the device D0 can be adjusted, which can improve the accuracy of the bonding position.

After the bonding between the first die D1 and the device D0, the third imaging portion 73 simultaneously captures both the alignment marks of the bonding surface of the first die D1 and the alignment marks of the bonding surface Wa of the target substrate W. For example, the third imaging portion 73 captures the alignment marks of the first die D1 and the target substrate W through the first die D1. The third imaging portion 73 is formed, for example, by an infrared camera.

When capturing the alignment marks of the first die D1 and the target substrate W through the first die D1, the third imaging portion 73 is disposed, for example, above the substrate holder 62, and is provided, for example, in the adsorption head 65a. The third imaging portion 73 transmits the captured image to the control circuitry 69. The control circuitry 69 performs image processing on the image captured by the third imaging portion 73, thereby detecting a deviation between the actual bonding position and the target bonding position.

The control circuitry 69 uses the image captured by the third imaging portion 73 to align the first die D1 held by the adsorption head 65a and the target substrate W held by the substrate holder 62 in the next and subsequent bonding between the first die D1 and the target substrate W. The position of the first die D1 or the target substrate W can be adjusted in consideration of behaviors of the bonder 60, thereby improving the accuracy of the bonding position.

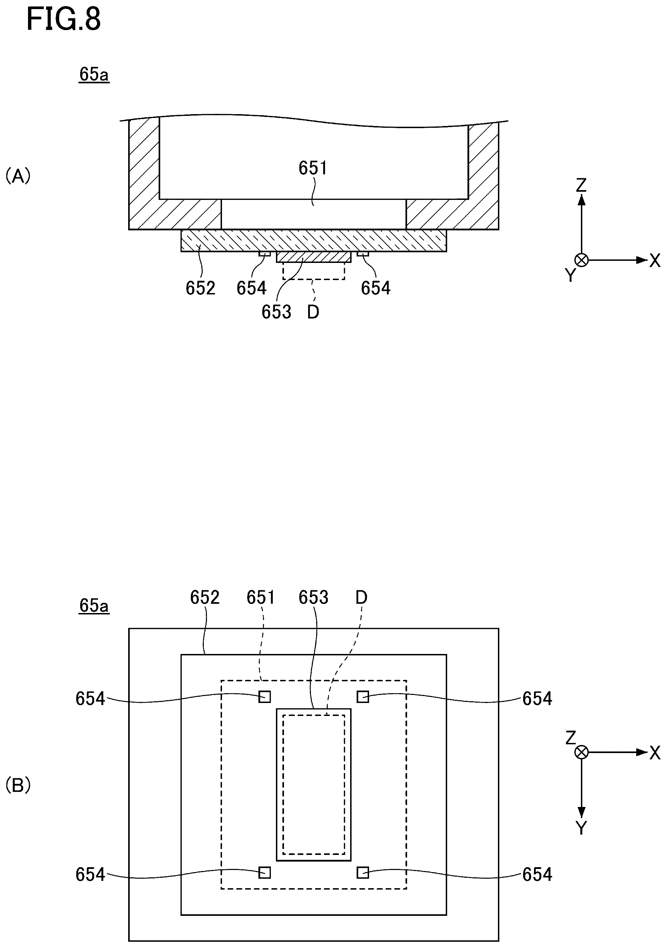

Next, an example of the structure of the tip of the adsorption head 65a will be described with reference to FIG. 8. Since the structure of the tip of the adsorption head 64a is the same as the structure of the tip of the adsorption head 65a, illustration and descriptions thereof will be omitted. As illustrated in FIG. 8, the adsorption head 65a includes, at the tip (e.g., the lower end), an opening 651, a transparent plate 652 covering the opening 651, a nozzle 653 attached to the transparent plate 652, and alignment marks 654 provided on the transparent plate 652.

The nozzle 653 adsorbs a die D. A nozzle 653 is preferably provided for each type of die D, and is preferably replaceable. By replacing the nozzle 653 in accordance with the type of the die D, the die D can be appropriately adsorbed. Although the replacement of the nozzle 653 is automatically performed under the control of the control circuitry 69 in the present embodiment, the replacement may be performed manually.

Although not illustrated, the second imaging portion 72 (see FIGS. 6 and 7) and the third imaging portion 73 (see FIGS. 6 and 7) may be provided inside of a housing of the adsorption head 65a. The second imaging portion 72 and the third imaging portion 73 image the target substrate W or the like through the transparent plate 652 and the opening 651 of the housing of the adsorption head 65a. The transparent plate 652 is, for example, a glass plate.

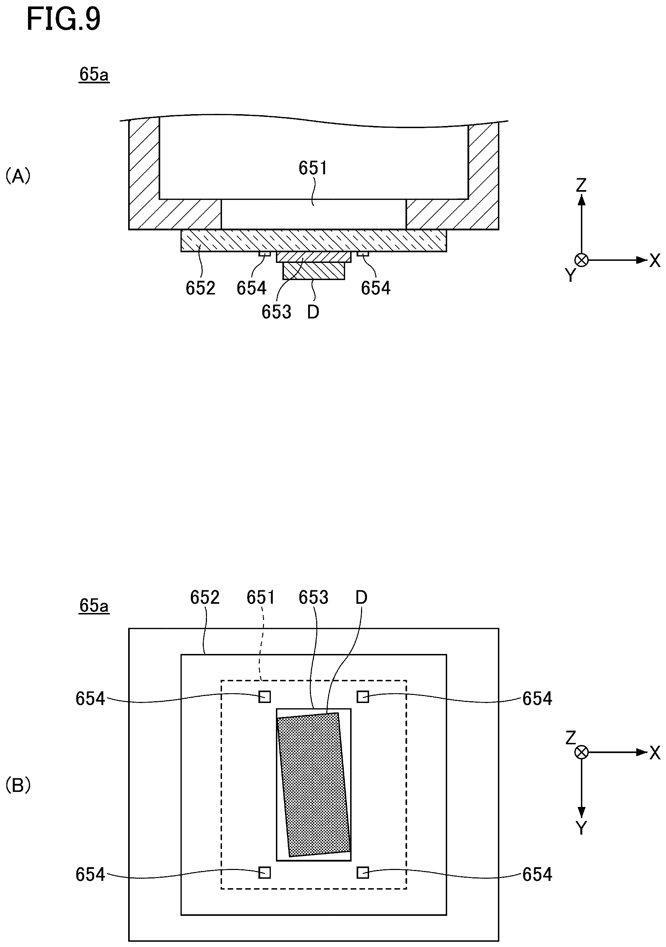

Next, an example of the adjustment of the relative position of the die D with respect to the adsorption head 65a will be described with reference to FIG. 9. Since the adjustment of the relative position of the die D with respect to the adsorption head 64a is the same as the adjustment of the relative position of the die D with respect to the adsorption head 65a, illustration and descriptions thereof will be omitted. The adjustment of the relative position of the die with respect to only one of the adsorption head 64a or 65a may be performed.

The adjustment of the relative position of the die D with respect to the adsorption head 65a includes, for example, the first imaging portion 71 capturing images of the nozzle 653 and the die D with the die D being adsorbed by the nozzle 653. The control circuitry 69 processes the image captured by the first imaging portion 71, thereby detecting the relative position of the die D with respect to the nozzle 653. Thus, the control circuitry 69 can correct a deviation of the relative position of the die D with respect to the nozzle 653 the next and subsequent times.

When a part (e.g., the nozzle 653) of the adsorption head 65a is replaced, the adjustment of the relative position of the die with respect to the adsorption head 65a is performed every time the part is replaced in order to maintain the accuracy of the bonding position. When the frequency of the adjustment is high, the production efficiency of the product is reduced. Therefore, it is preferable to use the same nozzle 653 of the adsorption head 65a in each bonder 60 as long as possible.

When the number of the bonders 60 is equal to or greater than the number of types of the dies, each bonder 60 can bond only one type of die set for each bonder 60 to the target substrate W. For example, one bonder 60 bonds only the first dies D1 to the target substrate W, and another bonder 60 bonds only the second dies D2 to the target substrate W.

However, the number of the bonders 60 may be less than the number of types of the dies. In this case, at least one bonder 60 bonds a plurality of types of dies to the target substrate W.

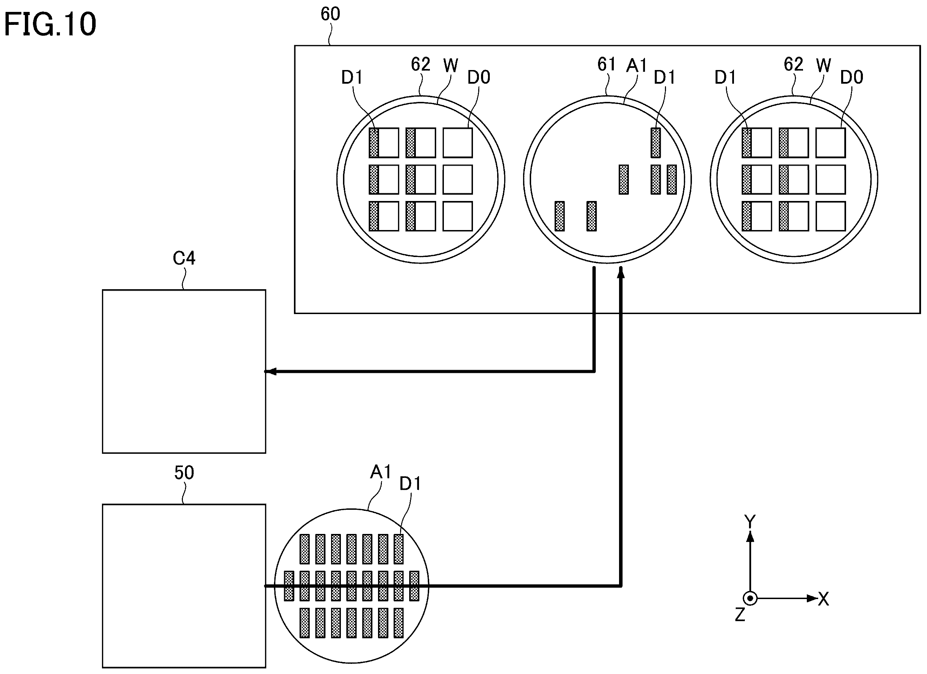

As illustrated in FIG. 10, even if the first dies D1 are left on the first carrier A1, in the absence of first dies D1 combinable with the device D0 from the viewpoint of quality, the control circuitry 69 generates a command to carry this first carrier A1 out from the bonder 60. Also, the control circuitry 69 generates a command to carry another first carrier A1 into the bonder 60. In accordance with these commands, the third transfer apparatus 52 replaces the first carrier A1 held by the carrier holder 61. Thus, the first dies D1 combinable with the device D0 can be supplied to the bonder 60, thereby continuing the bonding of the first dies D1 to the target substrate W.

The first carrier A1 from which some of the first dies D1 are separated by the bonder 60 is transferred to the second storage 50 by the third transfer apparatus 52; subsequently, transferred to the first storage 30 by the second transfer apparatus 32; and finally, transferred to the cassette C4 by the first transfer apparatus 22. The cassette C4 houses the first carrier A1 on which some of the first dies D1 are left. The first dies D1, which are left, are rearranged on the first carrier A1 outside of the bonding system 1, and returned to the bonding system 1 again.

After being stored in the first storage 30 or the second storage 50, the first carrier A1 on which some of the first dies D1 are left may be transferred to the bonder 60 again without being transferred to the cassette C4. The control circuitry 69 may monitor a vacant state of at least one of the second storage 50 or the first storage 30 using a sensor, such as a camera or the like, and determine, in accordance with the vacant state, whether the first carrier A1 on which some of the first dies D1 are left is transferred to the cassette C4, or transferred to the bonder 60 again without being transferred to the cassette C4.

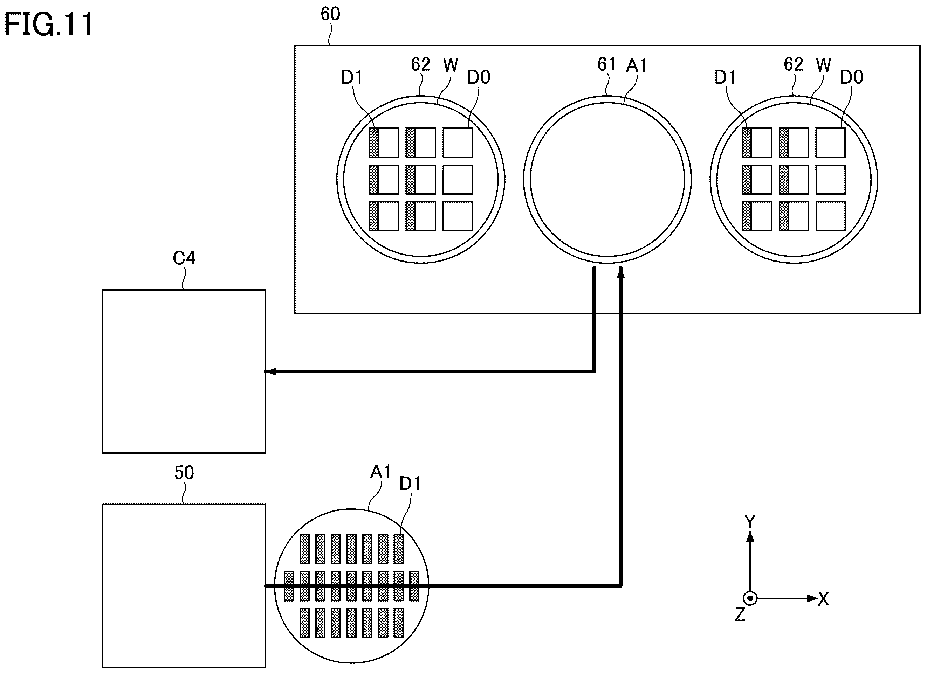

As illustrated in FIG. 11, the control circuitry 69 generates a command to carry one first carrier A1 out from the bonder 60 when all the first dies D1 are absent from the one first carrier A1. Also, the control circuitry 69 generates a command to carry another first carrier A1 into the bonder 60. In accordance with these commands, the third transfer apparatus 52 replaces the first carrier A1 held by the carrier holder 61. The first dies D1 combinable with the device D0 can be supplied to the bonder 60, thereby continuing the bonding of the first dies D1 to the target substrate W.

The first carrier A1 from which all the first dies D1 are separated by the bonder 60 is transferred to the second storage 50 by the third transfer apparatus 52; subsequently, transferred to the first storage 30 by the second transfer apparatus 32; and finally, transferred to the cassette C4 by the first transfer apparatus 22. The cassette C4 houses the first carrier A1 to which none of the first dies D1 are attached. The first carrier A1 from which all the first dies D1 have been separated is not transferred to the bonder 60 any more.

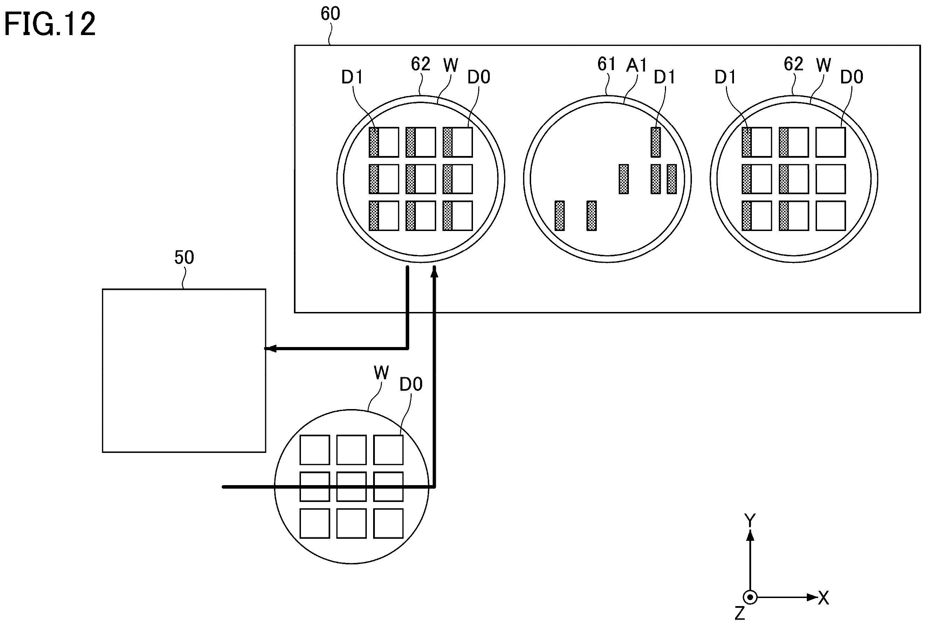

As illustrated in FIG. 12, after completion of the bonding of a predetermined number of the first dies D1 to one target substrate W, the control circuitry 69 generates a command to carry the one target substrate W out from the bonder 60 with the second dies D2 being unbonded. Also, the control circuitry 69 generates a command to carry another target substrate W, to which the first dies D1 are not bonded, into the bonder 60. In accordance with these commands, the third transfer apparatus 52 replaces the target substrate W held by the substrate holder 62, which can continue the bonding of the first dies D1 to the target substrate W.

The target substrate W, in which the first dies D1 are bonded to all the devices D0 by the bonder 60, is transferred to the second storage 50 by the third transfer apparatus 52, or further transferred to the first storage 30 by the second transfer apparatus 32. Then, the target substrate W is stored in the second storage 50 or the first storage 30 until being transferred again to the bonder 60. The bonding of the first dies D1 to the target substrate W and the bonding of the second dies D2 to the target substrate W may be performed by the same bonder 60, or may be performed by different bonders 60.

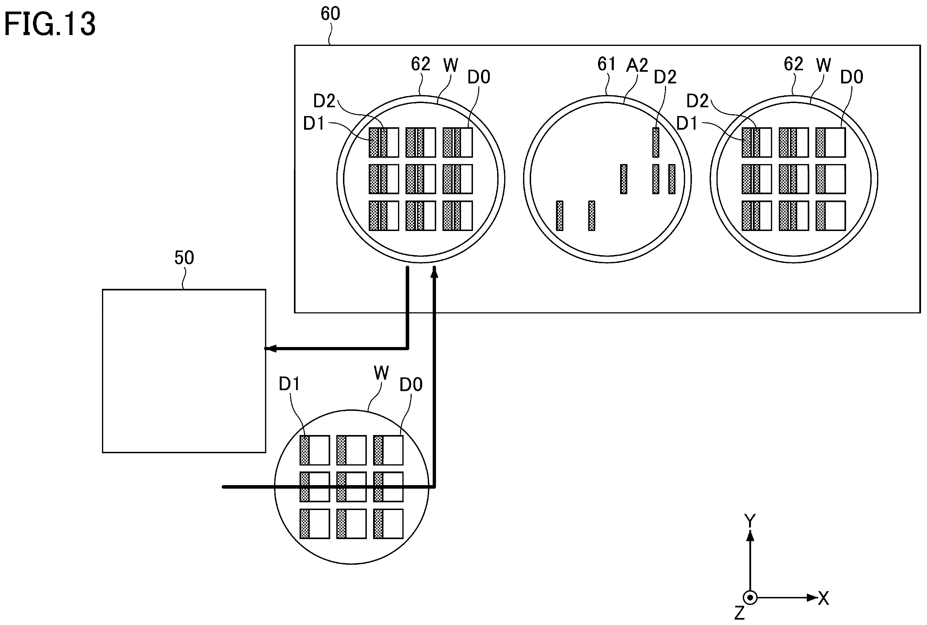

As illustrated in FIG. 13, after completion of the bonding of a predetermined number of the second dies D2 to one target substrate W, the control circuitry 69 generates a command to carry the one target substrate W out from the bonder 60. Also, the control circuitry 69 generates a command to carry, into the bonder 60, another target substrate W in which the bonding of the predetermined number of the first dies D1 is completed and the second dies D2 are not bonded. In accordance with these commands, the third transfer apparatus 52 replaces the target substrate W held by the substrate holder 62, which can continue the bonding of the second dies D2 to the target substrate W.

The target substrate W, in which the second dies D2 are bonded to all the devices D0 by the bonder 60, is transferred to the second storage 50 by the third transfer apparatus 52, or further transferred to the first storage 30 by the second transfer apparatus 32. Subsequently, when bonding of the third dies D3 is to be performed, the target substrate W is stored in the second storage 50 or the first storage 30 until being transferred again to the bonder 60. The bonding of the second dies D2 to the target substrate W and the bonding of the third dies D3 to the target substrate W may be performed by the same bonder 60, or may be performed by different bonders 60.

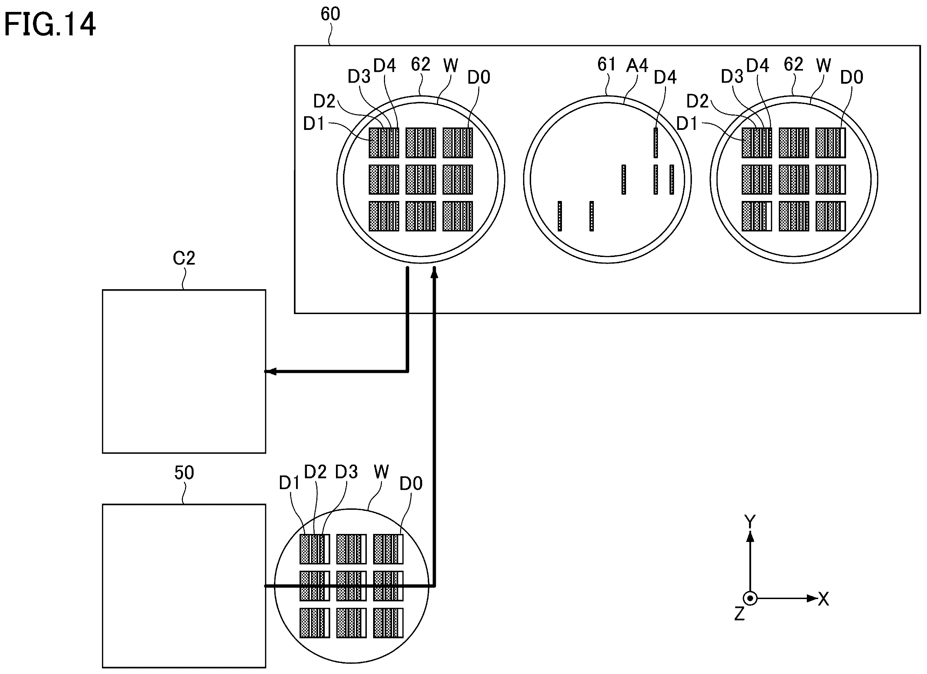

As illustrated in FIG. 14, after completion of the bonding of all types of the dies (e.g., a predetermined number of the first dies D1, a predetermined number of the second dies D2, a predetermined number of the third dies D3, and a predetermined number of the fourth dies D4) to one target substrate W, the control circuitry 69 generates a command to carry the one target substrate W out from the bonder 60. Also, the control circuitry 69 generates a command to carry, into the bonder 60, another target substrate W to which dies of only one type (e.g., the fourth dies D4) are not bonded. In accordance with these commands, the third transfer apparatus 52 replaces the target substrate W held by the substrate holder 62, which can continue the bonding of the fourth dies D4 to the target substrate W.

The target substrate W in which the bonding of all types of dies is completed by the bonder 60 is transferred to the second storage 50 by the third transfer apparatus 52; subsequently, transferred to the first storage 30 by the second transfer apparatus 32; and finally, transferred to the cassette C2 by the first transfer apparatus 22.

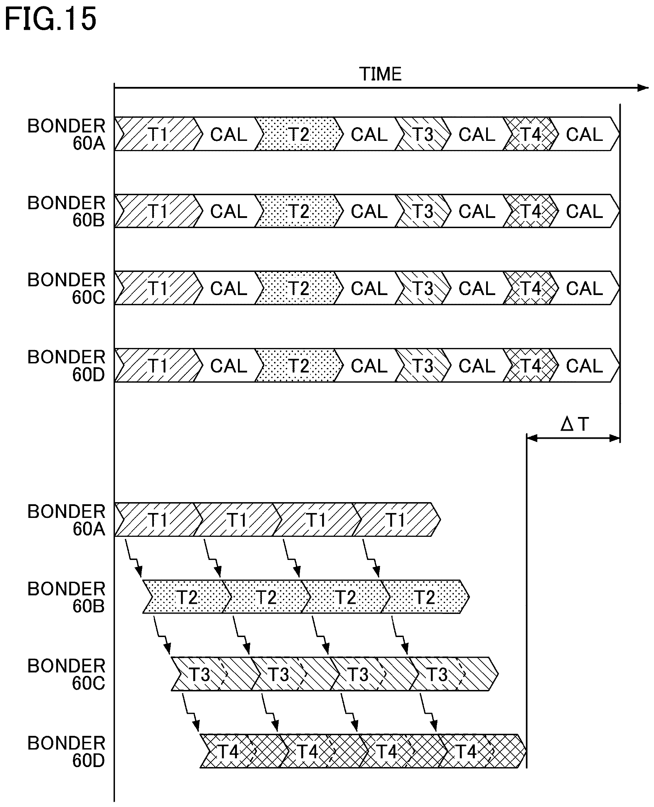

FIG. 15 is a diagram illustrating an example of a period required for each bonder to bond all types (e.g., four types) of dies to the target substrate W, and a period required for each bonder to bond only one type of die set for each bonder to the target substrate W. "T1" indicates a period required for bonding the first dies D1 to twenty-five target substrates W. "T2" indicates a period required for bonding the second dies D2 to twenty-five target substrates W. "T3" indicates a period required for bonding the third dies D3 to twenty-five target substrates W. "T4" indicates a period required for bonding the fourth dies D4 to twenty-five target substrates W. "CAL" indicates a period required for adjusting the relative position of the dies with respect to the adsorption head 65a.

As illustrated in the upper part of FIG. 15, when bonders 60A, 60B, 60C, and 60D bond all types of dies (e.g., four types) to the target substrate W, the nozzle 653 is replaced in accordance with the types of dies, and the relative position of the dies with respect to the adsorption head 65a is adjusted. As illustrated in the lower part of FIG. 15, when each of the bonders 60A, 60B, 60C, and 60D bonds, to the target substrate W, only one type of die set for each of the bonders 60A, 60B, 60C, and 60D, the adjustment of the relative position of the dies with respect to the adsorption head 65a is unnecessary. Therefore, it is possible to reduce the period for adjusting the bonders 60A, 60B, 60C, and 60D. For example, the period required for bonding all types of dies to the one-hundred target substrates W can be reduced by ΔT.

Therefore, when the number of the bonders 60A, 60B, 60C, and 60D is equal to or greater than the number of types of dies, the control circuitry 9 preferably performs the following controls (A) and (B). (A) During a desired period, the plurality of bonders 60A, 60B, 60C, and 60D repeatedly bond, to the target substrates W, only one type of die set for each of the plurality of the bonders 60A, 60B, 60C, and 60D while replacing the target substrates W. For example, the bonder 60A repeatedly bonds only the first dies D1 to the target substrates W while replacing the target substrates W. The bonder 60B repeatedly bonds only the second dies D2 to the target substrate W while replacing the target substrate W. The bonder 60C repeatedly bonds only the third dies D3 to the target substrates W while replacing the target substrates W. The bonder 60D repeatedly bonds only the fourth dies D4 to the target substrates W while replacing the target substrates W. (B) During the desired period, the third transfer apparatus 52 sequentially transfers each target substrate W to the plurality of the bonders 60A, 60B, 60C, and 60D that are configured to bond different types of dies to the target substrates W. Thus, it is possible to reduce the period for adjusting the bonders 60A, 60B, 60C, and 60D. For example, the period required for bonding all types of dies to the one-hundred target substrates W can be reduced by ΔT.

Here, the desired period is, for example, a period for bonding all types of dies to one or more lots formed by a plurality of target substrates W. One lot is formed by a plurality of (e.g., 25) target substrates W housed in one cassette C1. One lot may be formed by a plurality of (e.g., 25×n) target substrates W housed in a plurality of cassettes C1. Here, n is an integer of two or greater. No particular limitation is imposed on the upper limit of n, and n may be 10 or less.

Preferably, the control circuitry 9 simultaneously operates the plurality of bonders 60A, 60B, 60C, and 60D configured to bond different types of dies to the target substrate W during a part of the desired period. For example, the control circuitry 9 simultaneously performs the following (A1), (A2), (A3), and (A4). (A1) The bonder 60A repeatedly bonds the first dies D1 to the target substrates W while replacing the target substrates W. (A2) The bonder 60B repeatedly bonds the second dies D2 to the target substrates W while replacing the target substrates W. (A3) The bonder 60C repeatedly bonds the third dies D3 to the target substrates W while replacing the target substrates W. (A4) The bonder 60D repeatedly bonds the fourth dies D4 to the target substrates W while replacing the target substrates W. By simultaneously operating the plurality of bonders 60A, 60B, 60C, and 60D, the production efficiency of the product can be improved.

When the control circuitry 9 performs the controls of (A) and (B) (the control illustrated in the lower part of FIG. 15 is performed), T3 becomes longer than when the control illustrated in the upper part of FIG. 15 is performed. This is because the bonding of the third dies D3 is performed after the start of the bonding of the second dies D2. Similarly, T4 becomes longer because the bonding of the fourth dies D4 is performed after the start of the bonding of the third dies D3.

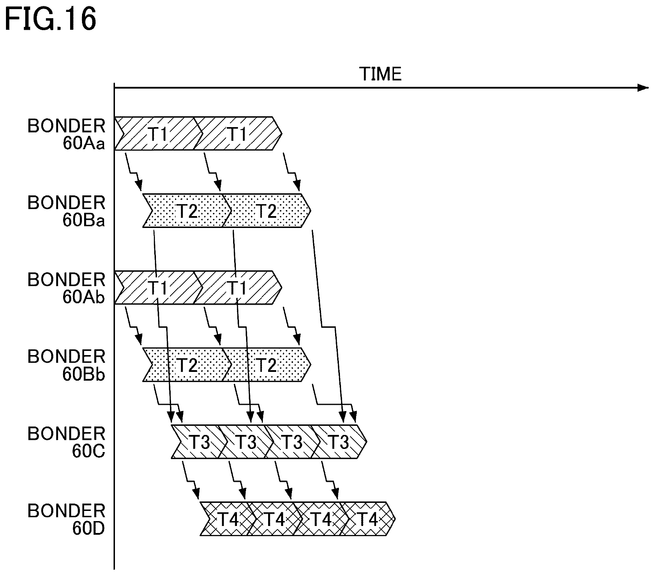

The unnecessary waiting period illustrated in the lower part of FIG. 15 occurs, for example, when N1, N2, N3, and N4 are not completely the same. Here, N1 is the number of the first dies D1 to be bonded to one target substrate W. N2 is the number of the second dies D2 to be bonded to one target substrate W. N3 is the number of the third dies D3 to be bonded to one target substrate W. N4 is the number of the fourth dies D4 to be bonded to one target substrate W. In each of the upper part and the lower part of FIG. 15, N1 and N2 are greater than N3 and N4. Therefore, in order to reduce the unnecessary waiting time illustrated in the lower part of FIG. 15, the control illustrated in FIG. 16, which will be described below, may be performed.

FIG. 16 is a diagram illustrating an example of types of dies to be bonded to the target substrate by each bonder when the number of the bonders is greater than the number of the types of the dies. The bonders 60Aa and 60Ab repeatedly bond only the first dies D1 to the target substrates W while replacing the target substrates W. The bonders 60Ba and 60Bb repeatedly bond only the second dies D2 to the target substrates W while replacing the target substrates W. The bonder 60C repeatedly bonds only the third dies D3 to the target substrates W while replacing the target substrates W. The bonder 60D repeatedly bonds only the fourth dies D4 to the target substrates W while replacing the target substrates W.

The control circuitry 9 determines the type of die to be bonded by each bonder to the target substrate W based on a proportion (e.g., N1:N2:N3:N4) of values obtained by counting the number of dies to be bonded to one target substrate W for each type of the dies. That is, the control circuitry 9 sets a proportion (e.g., n1:n2:n3:n4) of the numbers of bonders to be used based on the proportion (e.g., N1:N2:N3:N4). Here, n1 is the number of bonders configured to bond only the first dies D1. n2 is the number of bonders configured to bond only the second dies D2. n3 is the number of bonders configured to bond only the third dies D3. n4 is the number of bonders configured to bond only the fourth dies D4. This can reduce variation in the number of dies to be bonded by each bonder, and reduce the unnecessary waiting time. The proportion (e.g., n1:n2:n3:n4) of the numbers of bonders to be used is set to reduce the variation in the number of dies to be bonded by each bonder and to reduce the unnecessary waiting time.

The control circuitry 9 may use a proportion of values obtained by counting the number of dies to be bonded to one or more lots for each type of the dies, instead of the proportion obtained by counting the number of dies to be bonded to one target substrate W for each type of the dies. This is effective when the proportion (e.g., N1:N2:N3:N4) varies for each target substrate W. Such a case is, for example, a case in which one of a plurality of types of devices is selectively disposed at a specific position on the device D0. One example of this case is that the first die D1 or the second die D2 is selectively disposed at a specific position on the device D0. An instruction concerning which of the first die D1 and the second die D2 is disposed at a specific position on the device D0 may be included in the code indicating the quality.

The control circuitry 9 may determine the type of die to be bonded by each bonder to the target substrate W based on a proportion (e.g., K1:K2:K3:K4) of values obtained by counting the number of dies to be bonded to one or more lots for each type of the dies. K1 is the number of the first dies D1 to be bonded to one or more lots. K2 is the number of the second dies D2 to be bonded to one or more lots. K3 is the number of the third dies D3 to be bonded to one or more lots. K4 is the number of the fourth dies D4 to be bonded to one or more lots. The control circuitry 9 may set the proportion (e.g., n1:n2:n3:n4) of the numbers of bonders to be used based on the above proportion (e.g., K1:K2:K3:K4). This can reduce the variation in the number of dies to be bonded by each bonder, and reduce the unnecessary waiting time. The proportion (e.g., n1:n2:n3:n4) of the numbers of bonders to be used is set to reduce the variation in the number of dies to be bonded by each bonder, and to reduce the unnecessary waiting time.

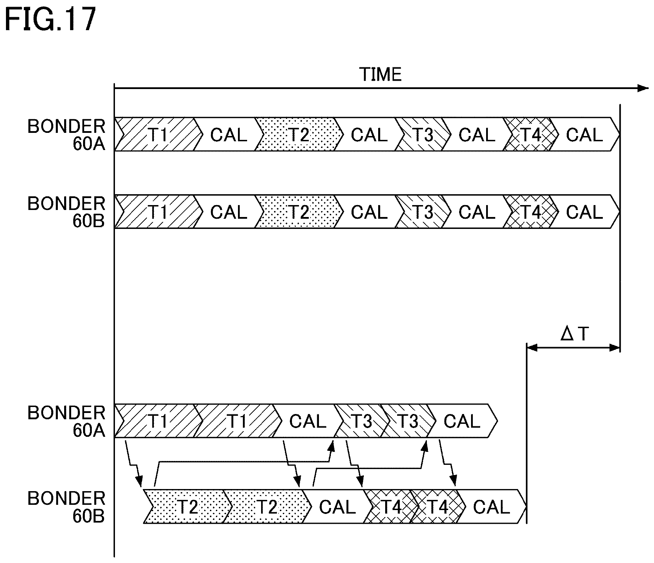

FIG. 17 is a diagram illustrating an example of types of dies to be bonded to the target substrate by each bonder when the number of the bonders is less than the number of the types of the dies. The control illustrated in FIG. 17 is also applicable when the number of bonders is equal to or greater than the number of types of dies. However, when the number of bonders is equal to or greater than the number of types of dies, it is preferable to perform the control illustrated in FIG. 15 or FIG. 16.

When the number of the bonders 60A and 60B is less than the number of types of dies, the control circuitry 9 preferably performs the following controls (C), (D), and (E). (C) During a desired period, the bonder 60A repeatedly bonds only the first dies D1 to the target substrates W while replacing the target substrates W, and subsequently, repeatedly bonds only the third dies D3 to the target substrates W while replacing the target substrates W. (D) During the desired period, the bonder 60B repeatedly bonds only the second dies D2 to the target substrates W while replacing the target substrates W, and subsequently, repeatedly bonds only the fourth dies D4 to the target substrates W while replacing the target substrates W. (E) During the desired period, the third transfer apparatus 52 transfers each target substrate W to the bonder 60A, the bonder 60B, the bonder 60A, and the bonder 60B in this order. Therefore, it is possible to reduce the period for adjusting the bonders 60A, 60B, 60C, and 60D. For example, the period required for bonding all types of dies to the fifty target substrates W can be reduced by ΔT.

Preferably, the control circuitry 9 simultaneously operates the plurality of bonders 60A and 60B configured to bond different types of dies to the target substrate W during a part of the desired period. For example, the control circuitry 9 simultaneously performs control to cause the bonder 60A to repeatedly bond only the first dies D1 to the target substrates W while replacing the target substrates W, and control to cause the bonder 60B to bond only the second dies D2 to the target substrates W while replacing the target substrates W. Also, the control circuitry 9 simultaneously performs control to cause the bonder 60A to repeatedly bond only the third dies D3 to the target substrates W while replacing the target substrates W, and control to cause the bonder 60B to bond only the fourth dies D4 to the target substrates W while replacing the target substrates W. By simultaneously operating the plurality of bonders 60A and 60B, the production efficiency of the product can be improved.

The embodiments and the like of the bonding system and bonding method according to the present disclosure have been described above. However, the present disclosure is not limited to the above embodiments and the like. Various changes, modifications, substitutions, additions, deletions, and combinations are possible within the scope of the claims. These fall within the technical scope of the present disclosure.

This application claims priority to Japanese Patent Application No. 2023-213488, filed with the Japan Patent Office on December 19, 2023, and the entire contents of Japanese Patent Application No. 2023-213488 are incorporated into the present application by reference.

### REFERENCE SIGNS LIST

- 1: Bonding system
- 9: Control circuitry
- 52: Third transfer apparatus (transfer apparatus)
- 60: Bonder
- W: Target substrate
- D0: Device
- D1: First die
- D2: Second die
- A1: First carrier
- A2: Second carrier

## Claims

1. A bonding system, comprising:
a plurality of bonders configured to separate dies from carriers to bond the separated dies to target substrates;
a transfer apparatus configured to transfer the carriers and the target substrates to the plurality of bonders; and
control circuitry configured to control the plurality of bonders and the transfer apparatus, wherein
a plurality of types of the dies are provided, and the plurality of the types of the dies are distinguished by at least one of a size or an electronic circuit,
a plurality of the carriers are provided, and the plurality of the carriers are configured to hold a plurality of only one type of the dies set for each of the carriers,
a number of the bonders is equal to or greater than a number of the types of the dies, and
the control circuitry is further configured to perform:
control to cause, during a desired period, the plurality of the bonders to repeatedly bond, to the target substrates, the only one type of the dies set for each of the plurality of the bonders while replacing the target substrates; and
control to cause, during the desired period, the transfer apparatus to sequentially transfer each of the target substrates to the plurality of the bonders that are configured to bond different types of the dies to the target substrates.

2. The bonding system according to claim 1, wherein
the control circuitry is further configured to:
during a part of the desired period, simultaneously operate the plurality of the bonders configured to bond different types of the dies to the target substrates.

3. The bonding system according to claim 1 or 2, wherein
the number of the bonders is greater than the number of the types of the dies, and
the control circuitry is further configured to perform:
control to determine the type of the dies to be bonded to the target substrates by each of the bonders based on a proportion obtained by counting a number of the dies to be bonded to one of the target substrates for each of the types of the dies.

4. The bonding system according to claim 1 or 2, wherein
the number of the bonders is greater than the number of the types of the dies, and
the control circuitry is further configured to perform:
control to determine the type of the dies to be bonded to the target substrates by each of the bonders based on a proportion obtained by counting a number of the dies to be bonded to one or more lots formed by the target substrates for each of the types of the dies.

5. The bonding system according to claim 4, further comprising:
a mounting table on which cassettes configured to house the carriers and cassettes configured to house the target substrates are to be placed, wherein
one of the lots is formed by the target substrates housed in one of the cassettes, or by the target substrates housed in a plurality of the cassettes.

6. A bonding system, comprising:
a plurality of bonders configured to separate dies from carriers to bond the separated dies to target substrates;
a transfer apparatus configured to transfer the carriers and the target substrates to the plurality of bonders; and
control circuitry configured to control the plurality of bonders and the transfer apparatus, wherein
the dies include first dies, second dies, and third dies, and the first dies, the second dies, and the third dies are different from each other in at least one of a size or an electronic component,
the carriers include a first carrier, a second carrier, and a third carrier, and the first carrier is configured to hold a plurality of the first dies, the second carrier is configured to hold a plurality of the second dies, and the third carrier is configured to hold a plurality of the third dies, and
the control circuitry is further configured to perform:
control to cause, during a desired period, one of the plurality of the bonders to repeatedly bond only the first dies to the target substrates while replacing the target substrates, and subsequently, repeatedly bond only the third dies to the target substrates while replacing the target substrates;
control to cause, during the desired period, another of the plurality of the bonders to repeatedly bond only the second dies to the target substrates while replacing the target substrates; and
control to cause, during the desired period, the transfer apparatus to transfer each of the target substrates to the one bonder, the another bonder, and the one bonder in this order.

7. The bonding system according to claim 6, wherein
the control circuitry is further configured to, during a part of the desired period, simultaneously perform:
control to cause the one bonder to repeatedly bond only the first dies to the target substrates while replacing the target substrates; and
control to cause the another bonder to repeatedly bond only the second dies to the target substrates while replacing the target substrates.

8. The bonding system according to claim 6 or 7, wherein
the dies further include fourth dies, and the first dies, the second dies, the third dies, and the fourth dies are different from each other in at least one of the size or the electronic component,
the carriers further include a fourth carrier, and the fourth carrier is configured to hold a plurality of the fourth dies, and
the control circuitry is further configured to perform:
control to cause, during the desired period, the another bonder to repeatedly bond only the second dies to the target substrates while replacing the target substrates, and subsequently, repeatedly bond only the fourth dies to the target substrates while replacing the target substrates; and
control to cause, during the desired period, the transfer apparatus to transfer each of the target substrates to the one bonder, the another bonder, the one bonder, and the another bonder in this order.

9. The bonding system according to claim 8, wherein
the control circuitry is further configured to, during a part of the desired period, simultaneously perform:
control to cause the one bonder to repeatedly bond only the third dies to the target substrates while replacing the target substrates; and
control to cause the another bonder to repeatedly bond only the fourth dies to the target substrates while replacing the target substrates.

10. The bonding system according to any one of claims 1, 2, 6, and 7, further comprising:
a mounting table on which cassettes configured to house the carriers and cassettes configured to house the target substrates are to be placed;
a first transfer region where the carriers and the target substrates are to be transferred;
a first storage configured to temporarily store the carriers and the target substrates;
a second transfer region where the carriers and the target substrates are to be transferred;
a second storage configured to temporarily store the carriers and the target substrates; and
a third transfer region where the carriers and the target substrates are to be transferred,
the mounting table, the first transfer region, the first storage, the second transfer region, the second storage, and the third transfer region being arranged in a row in this order, wherein
the bonders are next to the third transfer region, and
the transfer apparatus configured to transfer the carriers and the target substrates is provided in each of the first transfer region, the second transfer region, and the third transfer region.

11. A bonding method using the bonding system of any one of claims 1, 2, 6, and 7, the bonding method comprising:
separating the dies from the carriers to bond the separated dies to the target substrates.
